# NEUE EUROPÄISCHE PATENTSCHRIFT

(11) **EP 3 066 433 B2**
(45) Veröffentlichungstag und Bekanntmachung des Hinweises auf die Entscheidung über den Einspruch: **06.09.2023**
(45) Hinweis auf die Patenterteilung: 03.01.2018
(21) Anmeldenummer: 14792741.2
(22) Anmeldetag: 22.10.2014
(51) Int. Cl.: G01G 21/28, G01G 23/48, G01G 17/04

(54) **PRÄZISIONSWAAGE ODER MASSEKOMPARATOR MIT MODUL ZUR MESSUNSICHERHEITSBESTIMMUNG**
PRECISION SCALE OR MASS COMPARATOR WITH MODULE FOR DETECTING A MEASUREMENT UNCERTAINTY
BALANCE DE PRÉCISION OU COMPARATEUR DE MASSE MUNI D'UN MODULE DE DÉTERMINATION DE L'INCERTITUDE DE MESURE

(30) Priorität: 08.11.2013 DE 102013018767; 07.02.2014 DE 102014101563
(43) Veröffentlichungstag der Anmeldung: 14.09.2016
(73) Patentinhaber: Sartorius Lab Instruments GmbH & Co. KG, 37079 Göttingen (DE)
(72) Erfinder: RINDERMANN, Rainer, 37083 Göttingen (DE); PERTSCH, Thomas, 37077 Göttingen (DE); MÜHLICH, Sigo, 37120 Bovenden (DE); FEHLING, Thomas, 37218 Witzenhausen (DE); OSANG, Steffen, 37085 Göttingen (DE); GATZEMEIER, Benno, 37085 Göttingen (DE)
(74) Vertreter: Prinz & Partner mbB
(86) Internationale Anmeldenummer: PCT/EP2014/002853
(87) Internationale Veröffentlichungsnummer: WO 2015/067350

(56) Entgegenhaltungen:
- EP-A1- 1 785 703
- EP-A2- 0 864 852
- WO-A1-2013/163612
- DE-A1- 10 326 469
- DE-A1-102010 042 621
- DE-U1- 20 001 455
- DE-U1- 29 912 867
- DE-U1-202004 000 590
- US-B2- 9 354 109

## Beschreibung

Die Erfindung betrifft eine Präzisionswaage oder einen Massekomparator.

Bei derart hochauflösenden elektronischen Präzisionswaagen und Massekomparatoren stellt sich das Problem, dass eine Vielzahl von externen Parametern das Ergebnis der Wägung beeinflusst. Wenn bei der Massebestimmung eines Prüflings oder bei einem Wägevorgang der Messfehler kleiner als 10 ppm sein soll, kommt der Bediener kaum umhin, sich auch Gedanken über die Messunsicherheit zu machen.

Die Messunsicherheit wird unter anderem beeinflusst von der bei der Messung herrschenden Luftdichte, die sich auf den Auftrieb des Prüflings auswirkt und von der Umgebungstemperatur, dem Luftdruck und der Luftfeuchte abhängig ist. Auch der Benutzer hat einen Einfluss auf die Messergebnisse und damit die Messunsicherheit, da bereits die Art und Weise, wie die Messung durchgeführt wird, Einfluss darauf hat, wie genau ein bestimmtes Messergebnis reproduziert werden kann.

In der DE 37 14 540 C2 ist ein Verfahren zur automatischen Kalibrierung einer hochauflösenden Waage beschrieben, bei dem die Waage eine folge von Prüfschritten durchläuft, in denen die das Wägeergebnis beeinflussenden Störgrößen mit Grenzwerten verglichen werden und bei Unterschreiten der Grenzwerte eine Kalibrierung durchgeführt wird.

In der DE 299 12 867 U1 ist eine Waage gezeigt, die zumindest einen Messwertaufnehmer für Klimaparameter aufweist. Die Messwerte werden auf einer separaten Anzeigeeinheit ausgegeben.

Aus der EP 0 864 852 A2 ist eine elektronische Waage bekannt, die durch mehrmaliges Wiegen ein und derselben Last kalibriert wird und diese Daten statistisch auswertet, um die Messgenauigkeit zu erhöhen.

Wenn die Messunsicherheit des Wägevorgangs abgeschätzt werden soll, werden all diese Einflussfaktoren berücksichtigt. Hierzu gibt es z. B. in der internationalen Richtlinie der OIML R 111 Empfehlungen, wie die Abschätzung der Unsicherheit zu erfolgen hat. Im Stand der Technik sind hierzu PC-Programme und Excel-basierte Lösungen zur Unsicherheitsberechnung bekannt. In die dort verarbeiteten Formeln sind Angaben zur Waage, zum Klima und zu den Referenzgewichten einzugeben. Zusätzlich zum PC, der die Berechnung ausführt, sind auch externe Sensoren notwendig, mit denen die Klimadaten aufgenommen werden. Die Software auf dem PC errechnet aus den Wägewerten der Waage, aus den Klimasensorwerten, den eingegebenen Parametern der Referenzgewichte und den anderen Unsicherheitsparametern eine Gesamtunsicherheit für den Wägeprozess.

Der Nachteil dieser Lösung besteht darin, dass Daten von mehreren Systemen (Waage, Klimasensoren zur Luftdichtebestimmung, Referenzgewichte etc.) in einen PC übertragen werden müssen. Hier besteht grundsätzlich das Risiko einer Fehleingabe. Auch ist zur Auswertung immer ein PC nötig, der die Berechnung der Unsicherheit durchführt und der auf eine Datenbank mit Informationen (zum Beispiel Informationen der verwendeten Referenzgewichte) zurückgreift. Der Computer hat keinen Einfluss auf den gesamten Wägeprozess; er kann lediglich Wägewerte aus der Waage lesen. Die Waage kann also vereinfacht als ein Sensor angesehen werden, der die Wägewerte liefert.

Die Aufgabe der Erfindung besteht darin, eine Präzisionswaage oder einen Massekomparator und ein Verfahren bereitzustellen, mit der bzw. dem die Bestimmung der Messunsicherheit vereinfacht ist und die Messunsicherheit unmittelbar zusammen mit dem Wägeergebnis ausgegeben werden kann.

Zur Lösung dieser Aufgabe ist erfindungsgemäß eine Präzisionswaage vorgesehen, mit einem Wägeraum, einem Windschutz, der den Wägeraum umgibt, einem Klimamodul, das einen Luftdrucksensor, einen Luftfeuchtesensor und einen Lufttemperatursensor enthält und abnehmbar in dem Wägeraum angeordnet ist, einem Prozessor, der in der Präzisionswaage angeordnet ist, einer Dateneingabeeinheit, die an der Präzisionswaage angeordnet ist, und einer Datenübertragungsstrecke, die ausgebildet ist, Daten zwischen dem Klimamodul und dem Prozessor auszutauschen, wobei der Prozessor ein Messunsicherheitsbestimmungsmodul enthält, mit dem die Messunsicherheit der Waage ermittelt werden kann. Zur Lösung der Aufgabe ist weiterhin ein Verfahren zum Bestimmen der Messunsicherheit einer solchen Präzisionswaage oder eines Massekomparators vorgesehen, mit einem Wägeraum, der durch einen Windschutz zur Umgebung hin abgetrennt ist und in dem ein Luftdrucksensor, ein Luftfeuchtesensor und ein Lufttemperatursensor angeordnet sind, wobei die Sensoren mit einem Prozessor gekoppelt sind und wobei das Wägegut in Form eines Prüflings gewogen wird. Erfindungsgemäß werden während des Wägeprozesses der Luftdruck, die Luftfeuchte und die Lufttemperatur im Wägeraum mittels der Sensoren ermittelt. Weiterhin wird der Prüfling gewogen. Dann werden z. B. nach OIML R111-1 die folgenden Unsicherheiten bestimmt: Standardunsicherheit des Wägeverfahrens, Unsicherheit durch das verwendete Normal, Unsicherheit der Waage und die Unsicherheit der Luftauftriebskorrektur. Schließlich wird eine Gesamtunsicherheit zur Massebestimmung ermittelt. Die Erfindung beruht auf dem Grundgedanken, in die Waage all die Bauteile zu integrieren, die zur Bestimmung der Messunsicherheit nötig sind. Das Klimamodul liefert die Daten über das Mikroklima, das um den Prüfling herum herrscht, also innerhalb des Windschutzes. Auch etwaige Änderungen des Mikroklimas während des Wägeprozesses fließen sofort in die Bestimmung der Messunsicherheit ein. Es ist nicht notwendig, die erfassten Klimadaten und deren Unsicherheiten von Hand einzugeben; dadurch sind Fehleingaben verhindert. Da alle für die Bestimmung der Messunsicherheit nötigen Komponenten in die Waage selbst integriert sind, kann diese nach Art eines autarken Wägelabors vom Bediener dorthin transportiert werden, wo der Wägevorgang vorgenommen werden soll.

Allgemein ausgedrückt kann vorgesehen sein, dass der Anwender z. B. bei der Massekalibrierung nach OIML R111-1 sicher durch den Wägeprozess geführt wird und dabei neben der konventionellen Masse auch die reale Masse und alle relevanten Unsicherheiten berechnet werden. Am Ende der Massekalibrierung gibt die Waage eine Bewertung der Prüfgewichte nach vorgegebenen Genauigkeitsklassen ab, und es werden alle nötigen Daten für die Erstellung eines Prüfzertifikats zur Verfügung gestellt. Die Waage arbeitet wie ein Masselabor, da alle benötigten Sensoren und Daten zur Massebestimmung in die Waage integriert sind.

Die Waage enthält vorzugsweise ein Benutzerinterface (Display), um den Anwender nach vorgegebenem Ablaufprogramm z. B. durch eine Massekalibrierung zu führen. Dabei werden die zur Massebestimmung nötigen Lastwechsel von Referenz- und Prüfgewichten erkannt, und bei einer Fehlbedienung wird die Massekalibrierung abgebrochen. Die Waage macht Plausibilitätstests und Bewertungen anhand der Standardabweichung der Massedifferenzen zwischen Referenzgewicht und Prüfling und vergleicht diese mit früheren Standardabweichungen. Die erlaubten Unsicherheiten für eine zu kalibrierende Genauigkeitsklasse von Gewichten werden überprüft und bewertet. Die Waage kann auch die Türen des Windschutzes automatisch öffnen, um einen Lastwechsel zu ermöglichen. Alle notwendigen Sensoren zur Massebestimmung sind in die Waage integriert, und die Unsicherheiten aller Sensoren werden in der Waage gespeichert, um eine Gesamtunsicherheit für die Massebestimmung zu berechnen.

Die Standardunsicherheit des Wägeverfahrens u_{w} (Typ A) wird mit einer gemittelten Standardabweichung sₚ der Waage (an verschiedenen Tagen) ermittelt oder alternativ aus der Standardabweichung aus Massedifferenzen zwischen Referenzgewicht und Prüfling berechnet. Die Unsicherheiten (Typ B) der Referenzgewichte u(m_{cr}) und die Instabilitäten der Referenzgewichte Uᵢₙₛₜ(m_{cr}) sind in der Waage gespeichert und werden zur Berechnung der Gesamtunsicherheit verwendet. Die Unsicherheit (Typ B) der Luftauftriebskorrektur u_{b} wird errechnet aus den Unsicherheiten der in der Waage integrierten Klimasensoren für Temperatur, Luftdruck und relativer Luftfeuchte sowie aus den Unsicherheiten der Dichten von Referenz- und Prüfgewichten sowie dem Unsicherheitsanteil der Formel zur Berechnung der Luftauftriebskorrektur. Die Unsicherheitsanteile der Waage u_{ba} werden berechnet aus der Unsicherheit durch die Anzeigeauflösung der digitalen Waage, der Unsicherheit durch außermittige Belastung, durch magnetische Einflüsse der Probe (bzw. der Gewichte) und dem Unsicherheitsfaktor basierend auf der Empfindlichkeit der Waage.

Da das Klimamodul austauschbar (also zerstörungsfrei von der Waage lösbar) ist, kann es nach Bedarf zu einem externen Institut bzw. Dienstleister zum Kalibrieren geschickt werden. In der Zwischenzeit kann die Präzisionswaage oder der Massekomparator weiter betrieben werden, indem ein Austausch-Klimamodul eingesetzt wird. Es kann also immer rollierend eines oder (bei mehreren Präzisionswaagen) mehrere der Klimamodule beim Kalibrieren sein, während mit den übrigen Klimamodulen gemessen wird. Insgesamt wird dem Benutzer ein kompaktes Wägelabor an die Hand gegeben werden, das sogar transportabel ausgeführt sein kann und in dem sämtliche Bauteile und Funktionen, die für eine Luftauftriebskorrektur von Wägewerten nötig sind, in die Präzisionswaage oder Massekomparator zu vereinen. Es sind daher keine externen Computer, Sensoren, etc. notwendig. Hinsichtlich der Messunsicherheitsbestimmung ergibt sich als weiterer Vorteil, dass ältere Waagen nachgerüstet werden können. Es muss hierzu neben der Datenübertragungsstrecke lediglich die Software des Prozessors ergänzt werden.

Hinsichtlich der Genauigkeit hat die erfindungsgemäße Präzisionswaage den Vorteil, dass die Klimadaten im Windschutz (und nicht nur in dem Raum, in dem sich die Waage befindet) gemessen werden. Es wird also in unmittelbarer Nähe des Prüflings die Luftdichte ermittelt. Außerdem können, da die Auftriebswerte und deren Messunsicherheiten automatisch an den Prozessor übersandt werden, Übertragungsfehler praktisch ausgeschlossen werden, wie sie beim Übertragen von Werten aus dem sogenannten Kalibrierschein in eine Kalibriersoftware möglich sind.

Gemäß einer Ausführungsform ist vorgesehen, dass das Klimamodul mittels einer elektrischen Steckverbindung oder mittels einer Funkübertragung mit dem Prozessor verbunden ist. Die Steckverbindung kann in eine mechanische Aufnahme integriert sein, die zur Anbringung des Klimamoduls an der Präzisionswaage dient. Auf diese Weise wird die Datenübertragungsstrecke zum Prozessor automatisch dann erstellt, wenn das Klimamodul innerhalb des Windschutzes an seinem Platz angeordnet wird. Bei Verwendung einer Funkübertragung kann das Klimamodul an einer beliebigen Stellen innerhalb des Windschutzes angeordnet werden, beispielsweis an einer Seitenwand, an der es am wenigsten stört, ohne dass darauf Rücksicht genommen werden muss, ob an dieser Stelle sinnvoll eine Steckverbindung angeordnet werden kann. Außerdem ist der Verzicht auf eine Steckverbindung dahingehend vorteilhaft, dass der Innenraum der Wägekabine glatter und damit bessere reinigbar ausgeführt werden kann.

Es kann zusätzlich vorgesehen sein, dass ein Sensor, welcher mit dem Prozessor gekoppelt ist, vorhanden ist und ausgebildet ist, den Ionisationsgrad im Wägeraum zu bestimmen. Dadurch kann ein zusätzlicher Parameter bestimmt und bei der Korrektur des Wägewerts berücksichtigt werden. Abhängig von dem bestimmten Ionisationsgrad wird vom Prozessor ein Ausgangssignal erzeugt, z.B. um den Ionisationsgrad aktiv zu verändern, indem eine Ionisationseinrichtung verwendet wird, die ab Erreichen bestimmter Ionisationsgrade aktiviert wird. Ferner kann auch eine Anzeige dem Benutzer darauf hinweisen, dass der Ionisationsgrad innerhalb des Wägeraumes zu hoch ist und entladen werden sollte.

Es kann auch vorgesehen sein, dass ein Lichtsensor im Wägeraum vorhanden ist, welcher mit dem Prozessor gekoppelt ist. Dadurch kann ein wiederum weiterer Parameter bestimmt und bei der Korrektur des Wägewerts berücksichtigt werden. Der Prozessor kann ab einem vorgegebenen Lichteinfall ein Ausgangssignal abgeben. Der Einfluss des Lichteinfalls auf den Wägeprozess ist damit bestimmbar, um gegebenenfalls Maßnahmen im Prozess selbst zu ergreifen. Das Ausgangssignal kann auch eine Anzeige sein.

Gemäß einer Ausführungsform ist vorgesehen, dass der Prozessor so ausgebildet ist, dass er auf Basis der Dichte des Wägeguts aus dem Luftdruck, der Luftfeuchte und der Lufttemperatur im Wägeraum den Luftauftrieb zumindest des Prüflings oder den Auftriebskorrekturfaktor ermittelt. Auf diese Weise können vom Klimamodul metrologisch rückführbare Klimawerte zeitsynchron zur Übernahme des Wägewertes erhalten werden, mit denen der Prozessor in der Lage ist, den Wägewert zu korrigieren und die Masse oder die konventionelle Masse zu ermitteln und anzuzeigen..

Gemäß einer Ausführungsform ist ein elektronischer Speicher vorgesehen, insbesondere ein EEPROM, der von außen auslesbar ist und auf dem Kalibrierwerte und Korrekturwerte für das Klimamodul abgelegt werden können. Zum Justieren können die Kalibrierwerte und Korrekturwerte auf einem elektronischen Speicher auf dem Klimamodul abgelegt werden, insbesondere auf einem EEPROM. Dies kann auch ohne Waage erfolgen. Wenn das Klimamodul dann wieder an die Präzisionswaage angekoppelt wird, stehen diese Daten dem Prozessor der Waage unmittelbar zur Verfügung. Zusätzlich können auf dem Speicher unter anderem zumindest einige der folgenden Informationen zur Sensorkalibrierung abgelegt werden: Nummer des Kalibrierscheins, aktuelle Kalibrierwerte, Kalibrierdatum, Name des Kalibrierlabors und des Bearbeiters sowie Kalibrierhistorie. Auf dem Speicher des Klimamoduls können auch sogenannte Unsicherheitswerte für jede Klimagröße abgelegt sein, sodass zum Beispiel zur Berechnung der Luftdichte ebenso die Berechnung der Unsicherheit der Luftdichte durch die Präzisionswaage erfolgt.

Gemäß einer Ausgestaltung ist vorgesehen, dass das Klimamodul auch außerhalb einer Waage als selbständige Einheit einsetzbar ist und über einen I²C-Bus an einen USB-Port eines PC anschließbar ist. Dies erleichtert das externe Kalibrieren. Außerdem kann das Klimamodul in anderen Anwendungen dafür eingesetzt werden, Klimagrößen aufzunehmen, ohne dass es an eine Waage angeschlossen ist. Die Leiterplatte des Klimamoduls kann hierfür mit geringem Aufwand einen Steckfortsatz aufweisen, um an einen USB-Adapter angeschlossen werden zu können.

Zur Lösung der oben genannten Aufgabe ist ferner ein Verfahren zum Bestimmen der Messunsicherheit einer Präzisionswaage vorgesehen, mit einem Wägeraum, der durch einen Windschutz zur Umgebung hin abgetrennt ist und in dem ein Luftdrucksensor, ein Luftfeuchtesensor und ein Lufttemperatursensor angeordnet sind, wobei die Sensoren mit einem Prozessor gekoppelt sind und wobei Wägegut in Form eines Prüflings gewogen wird. Dabei werden der Luftdruck, die Luftfeuchte und die Lufttemperatur im Wägeraum mithilfe der Sensoren ermittelt, und der Prüfling wird gewogen. Weiterhin werden die Standardunsicherheit des Wägeverfahrens und die Unsicherheit der Masse des Prüflings bestimmt. Daraus wird eine Gesamtunsicherheit des Wägeergebnisses ermittelt. Hinsichtlich der sich ergebenden Vorteile wird auf die obigen Erläuterungen verwiesen.

Weiterhin kann vorgesehen sein, dass bei der Ermittlung der Gesamtunsicherheit auch das Ergebnis früherer Ermittlungen der Gesamtunsicherheit berücksichtigt wird. Anhand der Gesamtunsicherheit, die bei früheren Messungen ermittelt wurde, kann zum einen eine Plausibilitätsabschätzung der aktuell ermittelten Gesamtunsicherheit vorgenommen werden. Wenn die früher ermittelte Gesamtunsicherheit merklich geringer war als die aktuell ermittelte, kann dem Benutzer der Hinweis gegeben werden, dass der Wägevorgang insgesamt nicht zufriedenstellend verlaufen ist. Zum anderen kann die aktuell ermittelte Gesamtunsicherheit etwas nach oben korrigiert werden, wenn aktuell eine Gesamtunsicherheit ermittelt wurde, die merklich unter der Gesamtunsicherheit von früheren Wägevorgängen liegt.

Weitere Merkmale und Vorteile der Erfindung ergeben sich aus der nachfolgenden Beschreibung und aus den nachfolgenden Zeichnungen, auf die Bezug genommen wird. In den Zeichnungen zeigen:
- Figur 1 eine Explosionsansicht einer erfindungsgemäßen Präzisionswaage,
- Figur 2 eine Perspektivansicht eines Klimamoduls, das bei der erfindungsgemäßen Präzisionswaage eingesetzt werden kann,
- Figur 3 eine Seitenansicht des Klimamoduls nach Figur 2 ohne Außengehäuse,
- Figur 4 eine Draufsicht auf das Klimamodul von Figur 2, ebenfalls ohne Außengehäuse,
- Figur 5 ein Ablaufdiagramm, das ein Verfahren zum Betreiben der Waage wiedergibt, und
- Figur 6 ein Ablaufdiagramm, das ein Verfahren zur Bestimmung der Gesamtunsicherheit eines mit der Waage durchgeführten Massevergleiches nach OIML R111-1 wiedergibt.

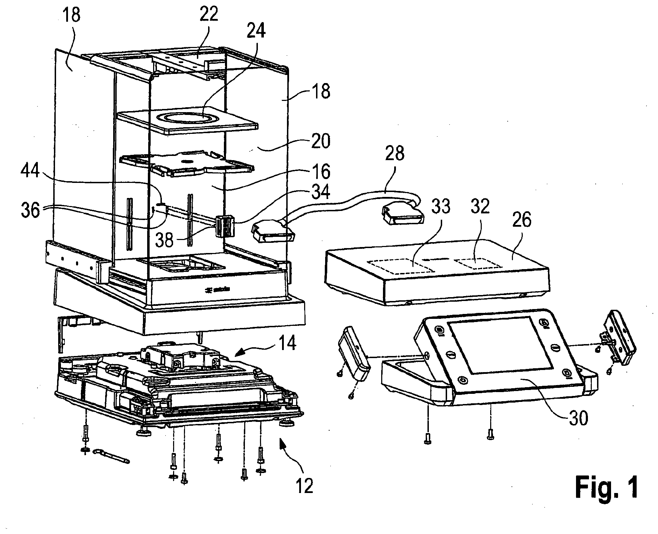

In Figur 1 ist eine hochauflösende elektronische Präzisionswaage dargestellt, die in diesem Ausführungsbeispiel Massevergleiche in den alle Genauigkeitsklassen nach OIML R 111-1 als auch nach ASTM E617-13 ermöglicht.

Die Präzisionswaage umfasst eine Wägezelle 14 mit einer Basis 12, in welche ein nicht näher dargestelltes Wägesystem 10 untergebracht ist. Die Wägezelle 14 umfasst darüber hinaus einen Wägeraum 16, der durch einen Windschutz mit verstellbaren Seitenwänden 18, einer Frontwand 20 sowie einer Rückwand 22 ausgebildet ist. Über den Windschutz ist der Wägeraum 16 zur Umgebung abgetrennt. Eine Waagschale 24 dient zum Auflegen des Wägeguts.

Ein hier als separates Teil ausgeführtes elektronisches Auswertesystem 26 ist über ein Kabel 28 mit der Wägezelle 14 elektronisch gekoppelt. Eine Anzeigeeinheit 30, die mit dem Auswertesystem 26 gekoppelt ist, dient sowohl als Anzeige als auch als Dateneingabeeinheit.

Im elektronischen Auswertesystem 26 ist unter anderem ein Prozessor 32 untergebracht, der Daten von der Wägezelle 14 erhält.

Im elektronischen Auswertesystem 26 ist weiterhin ein Messunsicherheitsbestimmungsmodul 33 vorgesehen, mit dem die Messunsicherheit eines aktuellen Wägeprozesses ermittelt werden kann. Weiterhin ist im Messunsicherheitsbestimmungsmodul 33 auch ein Speicher integriert, in dem die Gesamunsicherheit früherer Wägeprozesse abgespeichert wird.

Im Wägeraum 16 ist ein als baulich separate Einheit ausgeführtes Klimamodul 34 vorgesehen, welches über eine lösbare Steckverbindung mechanisch mit der Rückwand 22 koppelbar ist (also zerstörungsfrei lösbar angebracht ist), und zwar vorzugsweise ohne Zuhilfenahme eines Werkzeugs.

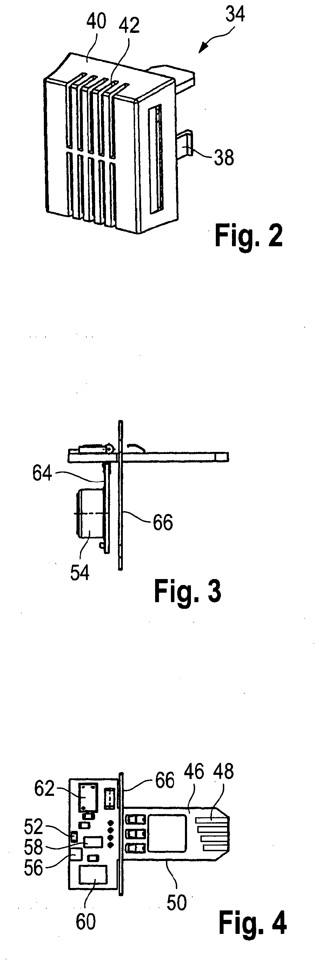

Hierzu weist die Rückwand 22 zwei voneinander beabstandete Schlitze 36 auf, in die flexible Rasthaken 38 (siehe auch Figur 2) am Außengehäuse 40 des Klimamoduls einrasten.

In den Figuren 2 bis 4 ist das Klimamodul 34 näher dargestellt.

Das Außengehäuse 40 hat zahlreiche Öffnungen 42, über die das Innere des Außengehäuses 40 in den Wägeraum 16 übergeht und Teil des Wägeraums 16 wird, sodass das Klima im Inneren des Wägeraums 16 dem im Inneren des Außengehäuses 40 entspricht.

Das Klimamodul 34 ist elektronisch über eine elektrische Steckverbindung mit einer entsprechenden Steckeraufnahme 44 in der Rückwand 22 gekoppelt. Die Steckeraufnahme 44 steht elektrisch mit dem Prozessor 32 in Verbindung. In die Steckeraufnahme 44 wird ein Stecker 46 mit Kontakten 48 am Klimamodul 34 eingesteckt. Somit bildet der Stecker 46 einen modulseitigen Teil der elektrischen Steckverbindung.

Alternativ zu einer elektrischen Steckverbindung kann eine Funkübertragung, beispielsweise WLAN oder Bluetooth, verwendet werden.

Die elektrische Steckverbindung (oder die alternativ verwendete Funkübertragung) bildet eine Datenübertragungsstrecke, mit der Daten vom Klimamodul 34 zum Prozessor 32 und ggfls. zurück übertragen werden können.

Der Stecker 46 ist vorzugsweise ein Abschnitt einer Leiterplatte 50, auf der mehrere Sensoren zum Erfassen des Klimas im Wägeraum 16 angeordnet sind. So sind ein Lufttemperatursensor 52, eine Luftfeuchtesensor 54, ein unmittelbar in der Nähe einer Öffnung 42 angeordneter Lichtsensor 56 sowie ein Sensor 58 zum Erfassen des Ionisationsgrads im Wägeraum 16 auf der Leiterplatte 50 vorgesehen, ebenso wie ein elektronischer Speicher 60. Ein Luftdrucksensor 62 ist über eine Halterung 64 mit der Leiterplatte 50 mechanisch und elektrisch gekoppelt.

Mehrere der Sensoren können auch zu kombinierten Sensoren zusammengefasst sein.

Eine Wand 66 schließt das schalenartige Außengehäuse 40, sodass der schmale, zungenartige, in Figur 4 rechts von der Wand 66 liegende Abschnitt der Leiterplatte 50 in die Rückwand 22 und die Steckeraufnahme 44 einsteckbar ist.

Über entsprechende Kontakte 48 ist jeder Sensor mit dem Prozessor 32 gekoppelt. Ebenso ist der Speicher 60 mit dem Prozessor 32 gekoppelt.

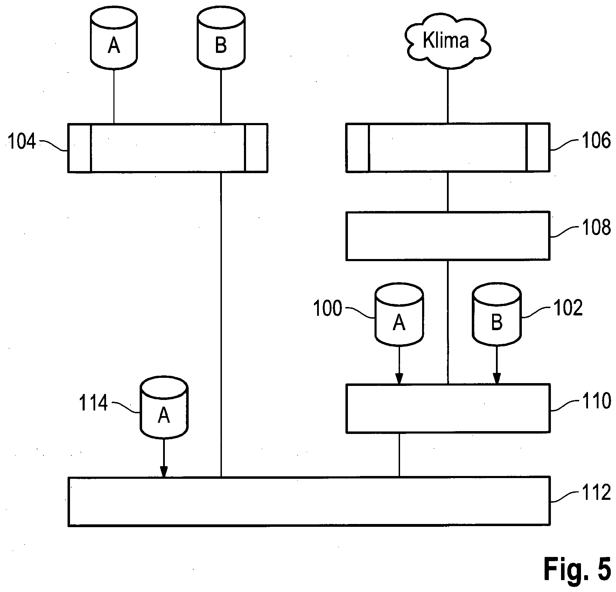

Die Waage arbeitet, wenn sie als Komparatorwaage betrieben wird, nach folgendem Verfahren, das anhand von Figur 5 erläutert wird:
Die Dichte des Wägeguts (Prüfgewicht, auch Prüfling B genannt, und Referenzgewicht A) wird in den Schritten 100 und 102 in die Komparatorwaage eingegeben, beispielsweise über die Anzeigeeinheit 30, die gleichzeitig zum Beispiel auch über Touch-Screen als Dateneingabeeinheit dient. Alternativ kann die Dichte des Wägeguts bereits hinterlegt sein.

Ein Wägegut wird auf die Waagschale 24 aufgelegt, und zwar nach vorgegebenen Ablaufschritten, z.B. zuerst das Referenzgewicht A, anschließend zweimal der Prüfling B und schließlich wieder das Referenzgewicht A. Es handelt sich um eine Vergleichswägung (doppelte Substitution), aus der im Schritt 104 sich die Anzeigedifferenz der Waage ergibt. Es sind auch andere Ablaufschritte möglich, beispielsweise ABA anstatt ABBA.

Der Luftdruck, die Luftfeuchte und die Lufttemperatur werden im Schritt 106 über die Sensoren 62, 54 bzw. 52 ermittelt, die entsprechenden Daten dann an den Prozessor 32 weitergeleitet.

Im Prozessor 32 wird die Luftdichte bestimmt, siehe Schritt 108. Mit den eingegebenen Dichten wird im Prozessor der Luftauftriebskorrekturfaktor im Schritt 110 und/oder der Luftauftrieb des Wägeguts abhängig vom Luftdruck, der Luftfeuchte, der Lufttemperatur sowie der Dichte des Wägeguts ermittelt und im Schritt 112 der konventionelle Wägewert des Prüflings B, d.h. die um ihren Luftauftrieb korrigierte Masse des Prüflings B, bestimmt und als Protokoll in der Anzeigeeinheit 30 wiedergegeben, wobei die konventionelle Masse 114 des Referenzgewichts in die Bestimmung der konventionellen Masse des Prüflings mit eingeht.

Darüber hinaus sind im Speicher 60 Kalibrierwerte und Korrekturwerte für das Klimamodul 34 abgelegt, die beim Kalibrieren des Klimamoduls 34 hinterlegt wurden.

Dieses Kalibrieren erfolgt außerhalb der Komparatorwaage. Hierzu wird das Klimamodul 34 einfach vom Wägeraum 16 aus ausgesteckt, ohne dass eine Drahtverbindung gelöst werden müsste. Das Klimamodul 34 wird dann zu einem entsprechenden Kalibrierinstitut geschickt, das die Nummer des Kalibrierscheins, das heißt die neuen Kalibrierwerte, das Kalibrierdatum, den Namen des Kalibrierlabors und des Bearbeiters und die Kalibrierhistorie auf dem Speicher 60 ablegt. Diese Werte werden vom Applikationsprogramm später, wenn das Klimamodul 34 wieder in der Präzisionswaage bzw. der Komparatorwaage ist, ausgelesen und fließen direkt in die Berechnung ein.

Auch die Werte des Lichtsensors 56 und des Sensors 58 zur Bestimmung des Ionisationsgrads im Wägeraum 16 werden bestimmt.

Beispielsweise wird bei erhöhtem Lichteinfall ein entsprechendes Signal auf der Anzeige angegeben werden, dass beispielsweise die Messung aufgrund erhöhter Sonneneinstrahlung und damit veränderter Temperatur im Wägeraum ungenau ist. Somit wird vom Prozessor ein Ausgangssignal abhängig vom Lichteinfall abgegeben.

Sobald der Ionisationsgrad zu hoch ist, wird eine Ionisationseinrichtung aktiviert, die die Luft im Wägeraum ionisiert und für eine Entladung des Wägeguts sorgt, oder es wird vor einer zu hohen Ladung des Wägeguts gewarnt.

Der Speicher 60 ist vorzugsweise ein EEPROM.

Darüber hinaus ist die Verbindung zwischen dem Klimamodul 34 und dem Rest der Präzisionswaage bzw. der Komparatorwaage über einen I²C-BUS realisiert.

Das Klimamodul 34 kann über einen USB-Adapter, in den es eingesteckt wird, an einen Computer angeschlossen werden, um die Sensoren 52 bis 58 und 62 zu kalibrieren, ohne dass das Klimamodul 34 an die Wägesystem 10 angeschlossen sein muss.

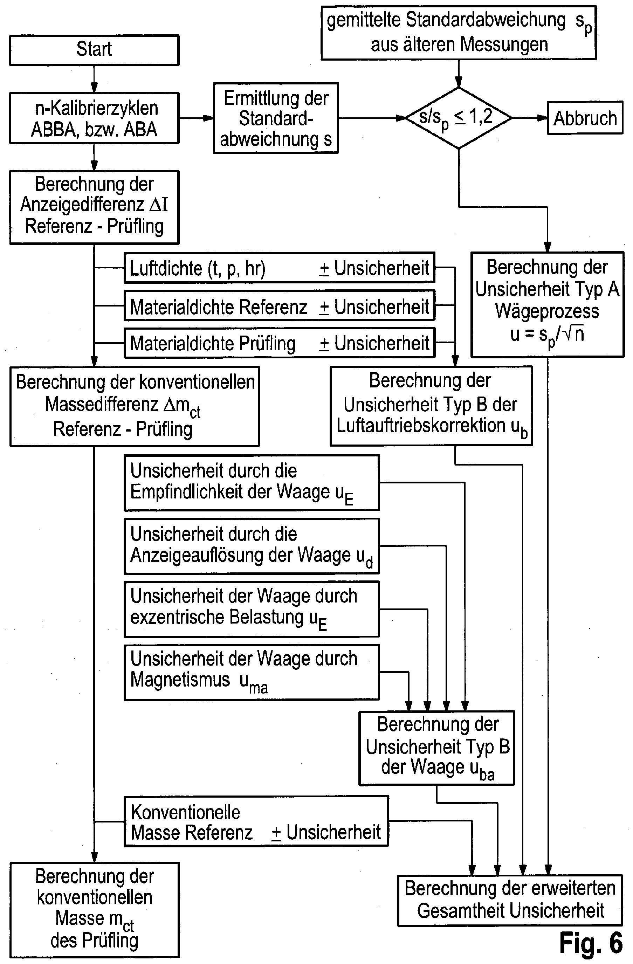

Die Gesamtunsicherheit der Massebestimmung wird auf die folgende Weise bestimmt (siehe auch Figur 6):
Aus den Ergebnissen der Kalibrierzyklen wird zunächst die Standardabweichung s bestimmt. Diese wird mit der gemittelten Standardabweichung sₚ von vorangegangenen Messungen verglichen. Die bei diesen Messungen ermittelte Standardabweichung ist in einem Speicher des Messunsicherheitsbestimmungsmoduls 33 abgelegt. Falls die Differenz zwischen der aktuellen Standardabweichung und der gemittelten Standardabweichung der früheren Messungen größer als ein als sinnvoll definierter Wert ist, wird der aktuelle Wägevorgang abgebrochen. Ansonsten wird aus der Standardabweichung die Unsicherheit des Typs A des Wägeprozesses bestimmt.

Die Unsicherheit des Typs B der Luftauftriebskorrektion u_{b} wird berechnet aus den Unsicherheiten der Luftdichte, der Materialdichte der Referenz und der Materialdichte des Prüflings. Die Werte für die Unsicherheit der Luftdichte sind im Klimamodul 34 gespeichert; sie wurden bei dessen Kalibrierung dort abgelegt.

Die Unsicherheit Typ B der Waage u_{ba} wird berechnet aufgrund der Unsicherheit durch die Empfindlichkeit der Waage u_{E}, der Unsicherheit durch die Anzeigeauflösung der Waage u_{d}, der Unsicherheit der Waage durch exzentrische Belastung u_{E} sowie der Unsicherheit der Waage durch Magnetismus uₘₐ.

Aus den Werten für die Unsicherheit des Typs B der Luftauftriebskorrektion sowie der Unsicherheit des Typs B der Waage, aus der Unsicherheit des Typs A für den Wägeprozess und zusätzlich aus der bekannten Unsicherheit der Masse der Referenz wird die erweiterte Gesamtunsicherheit des Wägeprozesses berechnet. Der besondere Vorteil besteht darin, dass dies integriert in der Waage mittels des Messunsicherheitsbestimmungsmoduls 33 erfolgen kann, der lediglich Informationen über den verwendeten Prüfling und die verwendete Referenz eingegeben werden müssen. Alle anderen Daten sind entweder dort hinterlegt oder werden automatisch abgefragt, beispielsweise durch Abrufen der im Klimamodul hinterlegten Unsicherheitswerte. Dies ermöglicht, bei einem Wägeprozess automatisiert die jeweilige Gesamtunsicherheit anzugeben.

## Patentansprüche

1. Präzisionswaage mit einem Wägeraum (16), einem Windschutz (18, 20, 22), der den Wägeraum (16) umgibt, einem Klimamodul (34), das einen Luftdrucksensor (62), einen Luftfeuchtesensor (54) und einen Lufttemperatursensor (52) enthält und abnehmbar in dem Wägeraum (16) angeordnet ist, einem Prozessor (32), der in der Präzisionswaage angeordnet ist, einer Dateneingabeeinheit, die an der Präzisionswaage angeordnet ist, und einer Datenübertragungsstrecke, die ausgebildet ist, Daten zwischen dem Klimamodul (34) und dem Prozessor(32) auszutauschen, wobei der Prozessor (32) ein Messunsicherheitsbestimmungsmodul (33) enthält, mit dem die Messunsicherheit der Waage ermittelt werden kann.

2. Präzisionswaage nach Anspruch 1, **dadurch gekennzeichnet, dass** das Klimamodul (34) mittels einer elektrischen Steckverbindung oder eine Funkübertragung mit dem Prozessor (32) verbunden ist.

3. Präzisionswaage nach einem der vorhergehenden Ansprüche, **dadurch gekennzeichnet, dass** ein Sensor (58), welcher mit dem Prozessor (32) gekoppelt ist, vorhanden ist und ausgebildet ist, den lonisationsgrad im Wägeraum (16) zu bestimmen.

4. Präzisionswaage nach einem der vorhergehenden Ansprüche, **dadurch gekennzeichnet, dass** ein Lichtsensor (56) im Wägeraum (16) vorhanden ist, welcher mit dem Prozessor (32) gekoppelt ist.

5. Präzisionswaage nach einem der vorhergehenden Ansprüche, **dadurch gekennzeichnet, dass** der Prozessor (32) so ausgebildet ist, dass er auf Basis der Dichte des Wägeguts aus dem Luftdruck, der Luftfeuchte und der Lufttemperatur im Wägeraum (16) den Luftauftrieb zumindest des Prüflings oder den Auftriebskorrekturfaktor ermittelt.

6. Präzisionswaage nach einem der vorhergehenden Ansprüche, **dadurch gekennzeichnet, dass** das Messunsicherheitsbestimmungsmodul einen Speicher aufweist, in dem das Ergebnis früherer Bestimmungen der Messunsicherheit hinterlegt ist.

7. Verfahren zum Bestimmen der Messunsicherheit einer Präzisionswaage nach einem der Ansprüche 1 bis 6, mit einem Wägeraum (16), der durch einen Windschutz zur Umgebung hin abgetrennt ist und in dem ein Luftdrucksensor (62), ein Luftfeuchtesensor (54) und ein Lufttemperatursensor (52) angeordnet sind, wobei die Sensoren (52, 54, 62) mit einem Prozessor (32) gekoppelt sind und wobei Wägegut in Form eines Prüflings gewogen wird, **gekennzeichnet durch** folgende Schritte:
- Ermitteln des Luftdruckes, der Luftfeuchte und der Lufttemperatur im Wägeraum (16) mithilfe der Sensoren (52, 54, 62);
- Wägen des Prüflings;
- Bestimmen der Standardunsicherheit des Wägeverfahrens;
- Bestimmen der Standardunsicherheit der Masse des Prüflings;
- Ermittelns einer Gesamtunsicherheit der Massebestimmung.

8. Verfahren nach Anspruch 7, **dadurch gekennzeichnet, dass** zusätzlich zum Prüfling auch ein Referenzgewicht (A) gewogen wird.

9. Verfahren nach einem der Ansprüche 7 und 8, **dadurch gekennzeichnet, dass** bei der Ermittlung der Gesamtunsicherheit auch das Ergebnis früherer Ermittlungen der Gesamtunsicherheit berücksichtigt wird.

## Claims

1. Precision weighing machine with a weighing space (16), a wind protector (18, 20, 22) surrounding the weighing space (16), an air conditioning module (34) which includes an air pressure sensor (62), a humidity sensor (54) and an air temperature sensor (52) and which is arranged in the weighing space (16) to be removable, a processor (32) arranged in the precision weighing machine, a data input unit arranged at the precision weighing machine, and a data transmission path configured to exchange data between the air conditioning module (34) and the processor (32), wherein the processor (32) includes a measuring uncertainty determination module (33) by which the measuring uncertainty of the weighing machine can be ascertained.

2. Precision weighing machine according to claim 1, **characterised in that** the air conditioning module (34) is connected with the processor (32) by means of an electrical plug connection or radio transmission means.

3. Precision weighing machine according to one of the preceding claims, **characterised in that** a sensor (58) which is coupled with the processor (32) is present and is constructed to determine the degree of ionisation in the weighing space (16).

4. Precision weighing machine according to any one of the preceding claims, **characterised in that** a light sensor (56) which is coupled with the processor (32) is present in the weighing space (16).

5. Precision weighing machine according to any one of the preceding claims, **characterised in that** the processor (32) is so constructed that on the basis of the density of the material to be weighed it determines from the air pressure, humidity and air temperature in the weighing space (16) the air buoyancy of at least the test item or the buoyancy correction factor.

6. Precision weighing machine according to any one of the preceding claims, **characterised in that** the measuring uncertainty determination module comprises a memory in which the result of earlier determinations of the measuring uncertainty is stored.

7. Method for determining the measuring uncertainty of a precision weighing machine according to any one of claims 1 to 6, comprising a weighing space (16) which is separated by a wind protector from the environment and in which an air pressure sensor (62), a humidity sensor (54) and an air temperature sensor (52) are arranged, wherein the sensors (52, 54, 62) are coupled with a processor (32) and wherein weighing material in the form of a test item is weighed, **characterised by** the following steps:
- determining the air pressure, humidity and air temperature in the weighing space (16) with the help of the sensors (52, 54, 62);
- weighing the test item;
- determining the standard uncertainty of the weighing method;
- determining the standard uncertainty of the mass of the test item;
- determining an overall uncertainty of the mass determination.

8. Method according to claim 7, **characterised in that** in addition to the test item a reference weight (A) is also weighed.

9. Method according to one of claims 7 and 8, **characterised in that** the result of earlier determinations of the overall uncertainty is also taken into consideration in the determination of the overall uncertainty.

## Revendications

1. Balance de précision comprenant une chambre de pesage (16), un pare-vent (18, 20, 22) qui entoure la chambre de pesage (16), un module de climatisation (34), qui contient un capteur de pression d'air (62), un capteur d'humidité d'air (54) et un capteur de température d'air (52) et qui est agencé de manière amovible dans la chambre de pesage (16), un processeur (32) qui est agencé dans la balance de précision, une unité de saisie de données qui est agencée sur la balance de précision, et une ligne de transmission de données qui est conçue pour échanger des données entre le module de climatisation (34) et le processeur (32), dans laquelle le processeur (32) contient un module de détermination d'incertitude de mesure (33) au moyen duquel l'incertitude de mesure de la balance peut être déterminée.

2. Balance de précision selon la revendication 1, **caractérisée en ce que** le module de climatisation (34) est relié au processeur (32) au moyen d'une connexion électrique à fiches ou d'une transmission radio.

3. Balance de précision selon l'une quelconque des revendications précédentes, **caractérisée en ce qu'**un capteur (58), lequel est couplé au processeur (32), est présent, et est conçu pour déterminer le degré d'ionisation dans la chambre de pesage (16).

4. Balance de précision selon l'une quelconque des revendications précédentes, **caractérisée en ce qu'**un capteur de lumière (56) est présent dans la chambre de pesage (16), laquelle est couplée au processeur (32).

5. Balance de précision selon l'une quelconque des revendications précédentes, **caractérisée en ce que** le processeur (32) est conçu de manière à établir la poussée aérostatique au moins de l'échantillon ou le facteur de correction de poussée, sur la base de la densité de l'article à peser, à partir de la pression d'air, de l'humidité de l'air et de la température de l'air dans la chambre de pesage (16).

6. Balance de précision selon l'une quelconque des revendications précédentes, **caractérisée en ce que** le module de détermination d'incertitude de mesure comprend une mémoire dans laquelle le résultat des déterminations antérieures de l'incertitude de mesure est mis en mémoire.

7. Procédé de détermination de l'incertitude de mesure d'une balance de précision selon l'une quelconque des revendications 1 à 6, comprenant une balance de pesage (16) qui est séparée de l'environnement par un pare-vent, et dans laquelle un capteur de pression d'air (62), un capteur d'humidité de l'air (54) et un capteur de température de l'air (52) sont agencés, dans lequel les capteurs (52, 54, 62) sont couplés à un processeur (32) et dans lequel l'article à peser est pesé sous forme d'un échantillon, **caractérisé par** les étapes suivantes :
- la détermination de la pression d'air, de l'humidité de l'air et de la température de l'air dans la chambre de pesage (16) à l'aide des capteurs (52, 54, 62) ;
- le pesage de l'échantillon ;
- la détermination de l'incertitude standard du procédé de pesage ;
- la détermination de l'incertitude standard de la masse de l'échantillon ;
- l'établissement d'une incertitude totale de la détermination de la masse.

8. Procédé selon la revendication 7, **caractérisé en ce qu'**un poids de référence (A) est pesé en plus de l'échantillon.

9. Procédé selon l'une quelconque des revendications 7 et 8, **caractérisé en ce que**, lors de l'établissement de l'incertitude totale, le résultat des établissements antérieurs de l'incertitude totale est également pris en compte.
